# EUROPEAN PATENT SPECIFICATION

(11) **EP 3 432 490 B1**
(45) Date of publication and mention of the grant of the patent: **10.07.2019**
(21) Application number: 17189575.8
(22) Date of filing: 06.09.2017
(51) Int. Cl.: H04B 17/11, H04B 17/29, H04B 17/15, H04B 17/00

(54) **MEASURING SYSTEM WITH POSITIONING SYSTEM FOR BEAMFORMING MEASUREMENTS AND MEASURING METHOD**
MESSSYSTEM MIT POSITIONIERUNGSSYSTEM FÜR STRAHLFORMUNGSMESSUNGEN UND MESSVERFAHREN
SYSTÈME DE MESURE COMPORTANT UN SYSTÈME DE POSITIONNEMENT POUR DES MESURES DE FORMATION DE FAISCEAU ET PROCÉDÉ DE MESURE

(30) Priority: 21.07.2017 EP 17182531
(43) Date of publication of application: 23.01.2019
(73) Proprietor: Rohde & Schwarz GmbH & Co. KG, 81671 München (DE)
(72) Inventor: Rowell, Corbett, 81545 Munich (DE); Abadie, Vincent, 82069 Höhenschäftlarn (DE)
(74) Representative: Körfer, Thomas

(56) References cited:
- EP-A1- 3 104 539
- GB-A- 2 531 310
- US-A1- 2012 038 522
- US-A1- 2014 141 726
- US-A1- 2015 116 164

## Description

The invention relates to measuring the accuracy of a device under test performing beamforming. Especially, the invention encompasses a measuring system and a measuring method for this purpose.

In order to perform accurate measurements, especially determining if a device under test correctly performs beamforming, over the air measurements are necessary. This means that a link antenna is in communications contact with the device under test and instructs the device under test to adopt specific beamforming parameters. A separate measuring antenna determines a transmission pattern around the device under test. In an ideal set up, the device under test, the link antenna and the measuring antenna can be positioned and/or oriented freely. In practice, this would be very complicated and would require a very complex measurement setup.

The US patent US 8,823,593 B2, shows a measuring system and method, in which the device under test is arranged on a turntable and can therefore only be turned around a single axis. Moreover, a measuring antenna is mounted rotatably around a perpendicular plane with regard to the rotation of the device under test. It is thereby possible to measure all positions around the device under test. The system and method shown there though is disadvantageous, since the use of a link antenna is not shown there.

Another document, US2012/0038522 shows an antenna characteristic measuring system and method. A device under test is arranged on a rotatable test stand which allows for a rotation of the device under test around a first axis.

The object of the invention is to provide a measuring system and a measuring method, which allow over the air measurements on a device under test for checking the beamforming compliance of the device under test.

The object is solved by the features of claim 1 for the system and by the features of claim 12 for the method. Dependent claims contain further developments.

According to a first aspect of the invention a measuring system comprising a measuring antenna, a link antenna and a positioning system is provided. A measuring antenna is configured for performing over the air measurements on a device under test. The link antenna is configured to perform communication with the device under test. The positioning system comprises a first rotational positioner, configured to rotate the device under test at least around a first axis. The positioning system moreover comprises a second rotational positioner, configured to rotate the measuring antenna at least around a second axis. The first rotational positioner is connected to the link antenna, and thereby configured to rotate the link antenna around the device under test around the first axis. It is thereby possible to measure a great plurality of different measuring positions and thereby check the beamforming compliance of then device under test.

According to a first preferred implementation form of the first aspect, the first rotational positioner is configured to rotate the link antenna together with the device under test around a position of the device under test, while not changing an alignment of the device under test with regard to the link antenna. This allows for a very simple construction of the system.

According to a second preferred implementation form of the first aspect, the first rotational positioner is configured to rotate the link antenna with a coordinate system of the device under test. This simplifies ensuing calculations significantly.

According to a third preferred implementation form of the first aspect, the positioning system comprises a third rotational positioner, configured to rotate the device under test around a third axis. This allows for positioning the link antenna at different angles with regard to the device under test by rotating the device under test with regard to the link antenna. Thereby, further degrees of freedom while performing the beamforming compliance tests is provided.

According to a further preferred implementation form of the first aspect, the third rotational positioner is configured to not rotate the link antenna around the third axis. The alignment between the device under test and the link antenna is thereby changed while rotating the device under test around the third axis.

According to a further preferred implementation form of the first aspect, the positioning system is configured form positioning the device under test in a spherical coordinate system. Thereby a great flexibility for performing the tests is given.

According to a further preferred implementation form of the first aspect, the measuring system comprises an anechoic chamber. The measuring antenna, the link antenna and the positioning system are then arranged in the anechoic chamber. This reduces outside interference on the measurement.

According to a further preferred implementation form of the first aspect, the measuring system comprises a measuring device connected to the measuring antenna. The measuring device is configured for measuring first measuring signals emitted by the device under test and received by the measuring antenna. Additionally or alternatively, the measuring device is configured for generating second measuring signals. In this case, the measuring antenna emits the second measuring signals towards the device under test. It is thereby possible to perform measurements in both measuring directions.

According to a further preferred implementation form of the first aspect, the measuring system comprises a link controller, configured for communicating with the device under test, by use of the link antenna. Great flexibility with regard to the signaling between the device under test and the link antenna is thereby achieved.

According to a further preferred implementation form of the first aspect, the link controller is configured for generating link control signals and transmitting them to the device under test, by use of the link antenna, the link control signals instructing the device under test to adjust at least one communication parameter. It is thereby possible to influence the device under test to switch between different operating modes, for example different beamforming patterns.

According to a further preferred implementation form of the first aspect, the at least one communication parameter is a beamforming parameter and/or MIMO parameter and/or a transmission parameter. Thereby, a great flexibility with regard to adjusting the settings of the device under test is achieved.

According to a further preferred implementation form of the first aspect, the positioning system comprises a fourth rotational positioner, configured to rotate the link antenna around a fourth axis. Additionally or alternatively, the positioning system comprises a longitudinal positioner, configured to move the link antenna longitudinally. Thereby, additional degrees of freedom for positioning the device under test with regard to the link antenna are achieved. A higher number of different test scenarios can thereby be performed by the measuring system.

According to a further preferred implementation form of the first aspect, the positioning system comprises a fifth rotational positioner, configured to rotate the device under test around the first axis (c) relative to the link antenna. This allows for an even greater flexibility of positioning of the link antenna.

According to a second aspect of the invention, a method for performing measurements on a device under test is provided. The method comprises instructing the device under test to adopt a beamforming, using a link antenna, positioning the device under test to direct the beamforming beam towards the link antenna, using a first rotational positioner, and performing a measurement, using a measuring antenna. It is thereby possible to determine measurements with minimal effort.

According to a first preferred implementation form of the second aspect, the method additionally comprises successively, after the step of performing a measurement, positioning the measuring antenna at a next measuring position, using a second rotational positioner, and performing measurements until measurements at a plurality of desired measurement positions have been performed. It is thereby possible to perform 3D measurements using only two different rotational positioners.

According to a further preferred implementation form of the second aspect, the method additionally comprises determining a 3D radiation pattern from the plurality of measurements. A very simple determining of measurement results is thereby possible.

According to a further preferred implementation form of the second aspect, the method additionally comprises, after the step of positioning the device under test to direct to beamforming beam towards the link antenna, using a rotational positioner, positioning the device under test to direct the beamforming beam towards the link antenna, using a third rotational positioner. It is thereby possible to three dimensionally align the device under test with regard to the link antenna and thereby determine three dimensional beamforming measurements.

An exemplary embodiment of the invention is now further explained with regard to the drawings by way of example only and not for limitation. In the drawings
- Fig. 1: shows a first embodiment of the measurement system according to the first aspect of the invention,
- Fig. 2: shows a second embodiment of the measurement system according to the first aspect of the invention, and
- Fig. 3: shows an embodiment of the measuring method according to the second aspect of the invention.

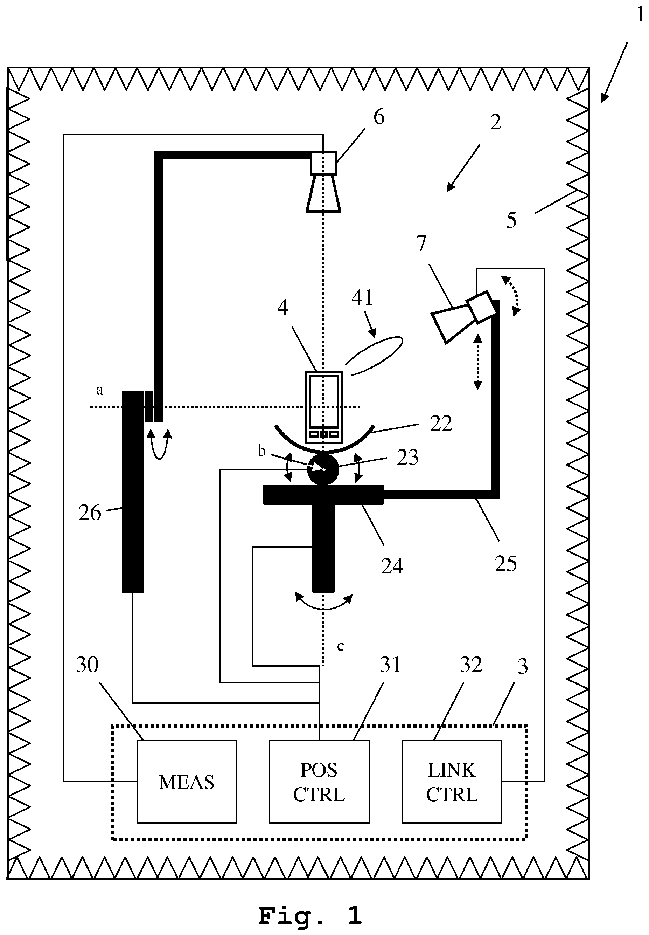

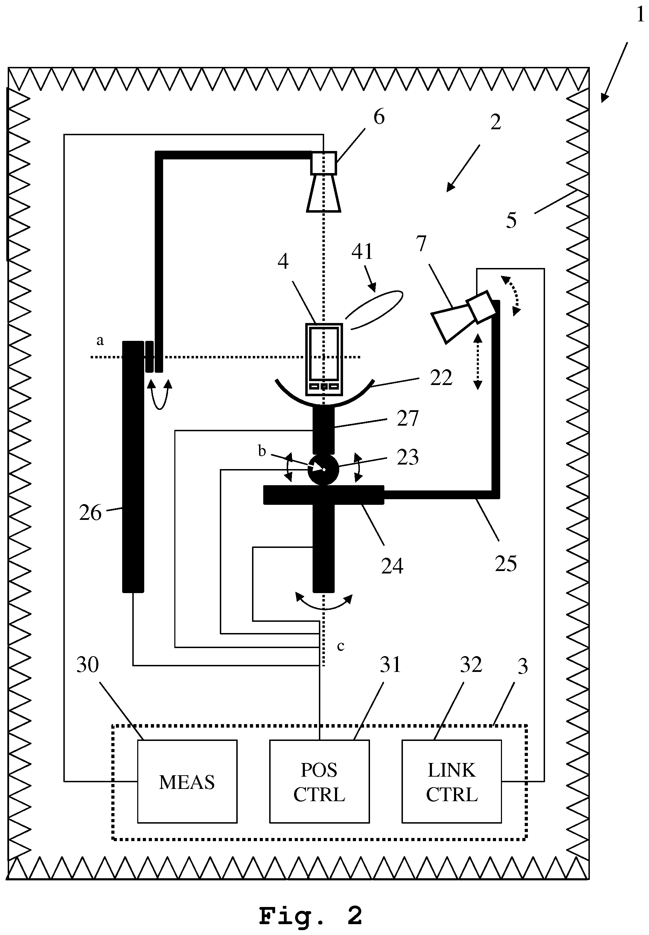

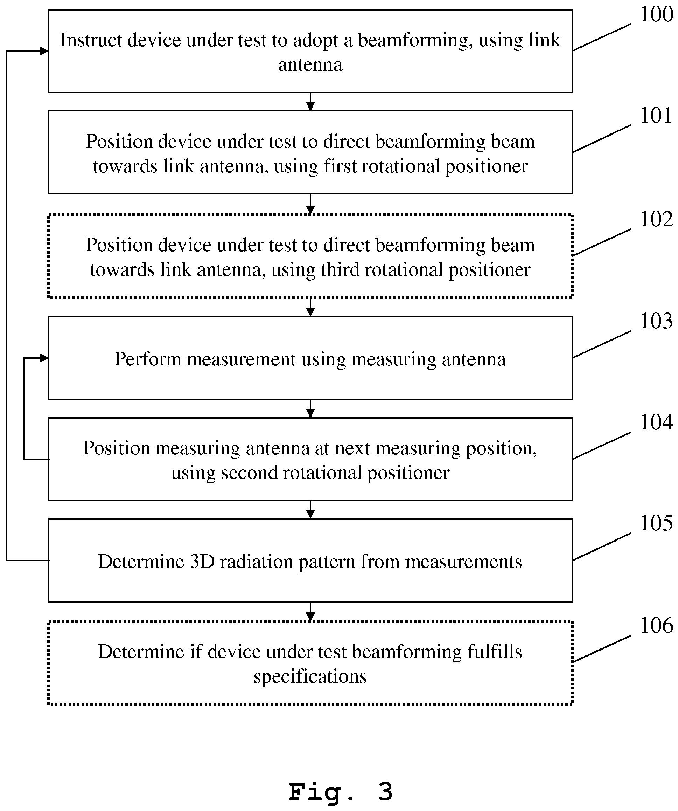

First, we demonstrate the construction and function of an embodiment of the first aspect of the invention along Fig. 1 and Fig. 2. Along Fig. 3, the function of an embodiment of the second aspect of the invention is shown in detail. Similar entities and reference numbers and different figures have been partially omitted.

In Fig. 1, an embodiment of a measuring system 1 according to the first aspect of the invention is shown. The measuring system 1 comprises a positioning system 2, which positions a device under test 4. The measuring system 1 moreover comprises a processing unit 3. The measuring system in addition comprises a measuring antenna 6 and a link antenna 7. The measuring antenna 6 and the link antenna 7 are also positioned by the positioning system 2.

The measuring system 1 also comprises an anechoic chamber 5, which encompasses the positioning system 2, the processing unit 3, and the device under test 4, the measuring antenna 6 and the link antenna 7. Alternatively, the processing unit 3 can be arranged outside of the anechoic chamber. It is important to note though, that the anechoic chamber 5 is an optional component.

The device under test 4 is held by a device under test holder 22. The device under test holder 22 mechanically connects the device under test 4 to a rotational positioner 23, which is adapted to rotate the device under test 4 with the device under test holder 22 around an axis b. The rotational positioner 23 is arranged on a turntable 24, which constitutes a further rotational positioner 24. The rotational positioner 24 is adapted to rotate the device under test 4, the device under test holder 22 and the rotational positioner 23 around an axis c. Connected to the turntable is an arm 25 holding the link antenna 7. This means that the link antenna 7 rotates with the turntable around the axis c and thereby around the device under test 4. As long as the rotational positioner 23 does not perform any rotation, the device under test 4 and the link antenna 7 stay aligned to each other without changing their angle with regard to each other, since the arm 25 fixedly connects the link antenna 7 to the turntable 24, even when the rotational positioner 24 rotates the device under test 4 and the device under test holder 22.

Optionally though, the link antenna 7 may be connected to the arm 25 by use of a further rotational positioner and/or by use of a longitudinal positioner. Thereby, the position and/or alignment of the link antenna 7 with regard to the device under test 4 can be adapted.

The measuring antenna 6 on the other hand is held in place by a further rotational positioner 26, which is adapted to rotate the measuring antenna 6 around an axis a. It is thereby possible to position the measuring antenna 6 around a 360° arch around the device under test 4. By use of the rotational positioners 23, 24 and 26, it is thereby possible to arrange the measuring antenna 6 in any direction with regard to the device under test 4.

The processing unit 3 comprises a measuring device 30, which is connected to the measuring antenna 6. In a first measuring direction, the measuring device 30 receives a first measuring signal emitted by the device under test and received by the measuring antenna 6. In a second measuring direction, the measuring device 30 generates a second measuring signal and emits it towards the device under test 4 by use of the measuring antenna 6. It is thereby possible to determine a three dimensional radiation pattern of signals emitted by the device under test but also of signal received by the device under test. Therefore, a transmission beamforming as well as reception beamforming can be tested.

Moreover, the processing unit 3 comprises a position controller 31, which is connected to the positioners 23, 24, 26. The position controller 31 controls the operation of the positioners 23, 24 and 26. In case of the link antenna 7 being connected to the arm 25 by a further positioner, this further positioner is also connected to the position controller 31 and controlled thereby.

The processing unit 3 moreover comprises a link controller 32, which is connected to the link antenna 7. The link controller 32 controls the communication between the device under test 4 and the link antenna 7 and receives and generates respective signals. Especially, the link controller 32 generates a link signal and transmits it to the device under test 4 by use of the link antenna 7, in order to instruct the device under test 4 to adopt a specific communication parameter, for example a beamforming parameter or a MIMO parameter or any other form of communication parameter.

The use of the anechoic chamber 5 ensures that no stray emissions from outside influence the measurements.

In Fig. 1, a beam 41 of a signal emitted by the device under test 4 is shown. This beam can for example be achieved by beamforming.

In Fig. 2, a second embodiment of the measurement system 1 is shown. Here, the positioning system 2 comprises an additional rotational positioner 27, which is arranged between the device under test holder 22 and the rotational positioner 23, and mechanically connects the device under test holder 22 and the rotational positioner 23. The rotational positioner 27 is adapted to rotate the device under test 4 together with the device under test holder 22 around the axis c. This rotation is independent of the rotation by the rotational positioner 24, which rotates the device under test holder 22, the rotational positioner 27, and the rotational positioner 23.

Therefore, by use of the rotational positioner 24, it is possible to rotate the device under test 4 together with the link antenna 7, without changing the alignment of the device under test 4 with regard to the link antenna 7.

By use of the rotational positioner 27, it is possible to rotate the device under test 4 with regard to the link antenna 7 as well as with regard to the measuring antenna 6.

In Fig. 3, an embodiment of the measuring method according to the second aspect of the invention is shown. In a first step 100 a device under test is instructed to adopt a specific beamforming, using a link antenna. In a second step 101, the device under test is positioned to direct the beamforming beam towards the link antenna using a first rotational positioner. Optionally, if there are more positioners, especially rotational positioners available covering more degrees of freedom, they can also be used to position the device under test with regard to the link antenna, here.

In a third step 102, which is an optional step, the device under test is moreover positioned to direct the beamforming beam towards the link antenna using a third rotational positioner. If this step is employed, a three dimensional positioning with regard to the link antenna is possible. Optionally, if there are more positioners, especially rotational positioners available covering more degrees of freedom, they can also be used to position the device under test with regard to the measuring antenna, here.

In a fourth step 103 a measurement is performed using a measuring antenna. In a fifth step 104, the measuring antenna is positioned at a next measuring position using a second rotational positioner. After this step, the steps 103 and 104 are repeated, until all measuring positions with regard to the present beamforming setup are measured. In a sixth step 105 a three dimensional radiation pattern is determined from these measurements. Now the steps 100 - 105 are repeated for a number of different beamforming settings. Finally, in an optional seventh 107, it is determined if the device under test fulfils beamforming specifications, by for example comparing the determine 3D radiation patterns with a look-up table.

The invention is not limited to the examples and especially not to specific types of devices under test. The characteristics of the exemplary embodiments can be used in any advantageous combination.

While various embodiments of the present invention have been described above, it should be understood that they have been presented by way of example only, and not limitation. Numerous changes to the disclosed embodiments can be made in accordance with the disclosure herein without departing from the scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. Measuring system comprising a measuring antenna (6), a link antenna (7), and a positioning system (2),
wherein the measuring antenna (6) is configured to perform over the air measurements on a device under test (4),
wherein the link antenna (7) is configured to perform communication with the device under test (4),
wherein the positioning system (2) comprises
- a first rotational positioner (24), configured to rotate the device under test (4) around at least a first axis (c), and
- a second rotational positioner (26), configured to rotate the measuring antenna (6) around at least a second axis (a),
wherein the first rotational positioner (24) is connected to the link antenna (7) and is configured to rotate the link antenna (7) around the device under test (4), around the first axis (c).

2. Measuring system according to claim 1,
wherein the first rotational positioner (24) is configured to
- rotate the link antenna (7) together with the device under test (4) around a position of the device under test (4), and
- not change an alignment of the device under test (4) with regard to the link antenna (7).

3. Measuring system according to claim 1,
wherein the first rotational positioner (24) is configured to rotate the link antenna (7) with a coordinate system of the device under test (4).

4. Measuring system according to claim 1,
wherein the positioning system (2) comprises a third rotational positioner (23), configured to rotate the device under test (4) around a third axis (b).

5. Measuring system according to claim 4,
wherein the third rotational positioner (23) is configured to not rotate the link antenna (7) around the third axis (b).

6. Measuring system according to claim 4,
wherein the positioning system (2) is configured for positioning the device under test (4) in a spherical coordinate system.

7. Measuring system according to any of the claims 1 to 6, comprising an anechoic chamber (5),
wherein the measuring antenna (6), the link antenna (7), and the positioning system (2), are arranged in the anechoic chamber (5).

8. Measuring system according to any of the claims 1 to 7, comprising a measuring device (30) connected to the measuring antenna (6), configured for
- measuring first measuring signals emitted by the device under test (4) and received by the measuring antenna (6), and/or
- generating second measuring signals, wherein the measuring antenna (6) is configured for emitting the second measuring signals towards the device under test (4).

9. Measuring system according to any of the claims 1 to 8, comprising a link controller (32), configured for communicating with the device under test (4), by use of the link antenna (7).

10. Measuring system according to claim 9,
wherein the link controller (32) is configured for generating link control signals and transmitting them to the device under test (4), by use of the link antenna (7), wherein the link control signals instruct the device under test (4) to adjust at least one communication parameter.

11. Measuring system according to claim 10,
wherein the at least one communication parameter is a beamforming parameter and/or a MIMO parameter and/or a transmission pattern.

12. Measuring system according to any of the claims 1 to 11,
wherein the positioning system (2) comprises a fourth rotational positioner, configured to rotate the link antenna (7) around a fourth axis, and/or
wherein the positioning system (2) comprises a longitudinal positioner, configured to move the link antenna (7) longitudinally.

13. Measuring system according to any of claims 1 to 12,
wherein the positioning system (2) comprises a fifth rotational positioner (27), configured to rotate the device under test (4) around the first axis (c) relative to the link antenna (7).

14. Method for performing measurements on a device under test (4), comprising:
- instructing (100) the device under test (4) to adopt a beamforming, using a link antenna (7),
- positioning (101) the device under test (4) to direct the beamforming beam towards the link antenna (7), using a first rotational positioner (24), and
- performing (103) a measurement, using a measuring antenna (6).
- rotating the link antenna around the device under test around a first axis c using the first rotational positioner,
- rotating the measuring antenna around a second axis a using a second rotational positioner

15. Method according to claim 14,
wherein the method additionally comprises, successively, after the step of performing a measurement, positioning (104) the measuring antenna (6) at a next measuring position, using a second rotational positioner (26), and performing measurements,
until measurements at a plurality of desired measurement positions have been performed.

16. Method according to claim 15,
wherein the method additionally comprises determining (105) a three dimensional radiation pattern from the plurality of measurements.

17. Method according to any of the claims 14 to 16,
wherein the method additionally comprises, after the step of positioning (101) the device under test (4) to direct the beamforming beam towards the link antenna (7), using a first rotational positioner (24), positioning (102) the device under test (4) to direct the beamforming beam towards the link antenna (7) and using a third rotational positioner (23).

## Patentansprüche

1. Messsystem mit einer Messantenne (6), einer Verbindungsantenne (7) und einem Positionierungssystem (2),
wobei die Messantenne (6) dazu konfiguriert ist, Messungen durch die Luft an einem Prüfobjekt (4) durchzuführen,
wobei die Verbindungsantenne (7) dazu konfiguriert ist, eine Kommunikation mit dem Prüfobjekt (4) durchzuführen,
wobei das Positionierungssystem (2)
- eine erste Drehpositioniereinrichtung (24) aufweist, die zum Drehen des Prüfobjektes (4) um mindestens eine erste Achse (c) konfiguriert ist, und
- eine zweite Drehpositioniereinrichtung (26) aufweist, die zum Drehen der Messantenne (6) um mindestens eine zweite Achse (a) konfiguriert ist,
wobei die erste Drehpositioniereinrichtung (24) mit der Verbindungsantenne (7) verbunden ist und dazu konfiguriert ist, die Verbindungsantenne (7) um das Prüfobjekt (4) um die erste Achse (c) zu drehen.

2. Messsystem nach Anspruch 1,
wobei die erste Drehpositioniereinrichtung (24) dazu konfiguriert ist,
- die Verbindungsantenne (7) zusammen mit dem Prüfobjekt (4) um eine Position des Prüfobjektes (4) zu drehen, und
- eine Ausrichtung des Prüfobjektes (4) bezüglich der Verbindungsantenne (7) nicht zu verändern.

3. Messsystem nach Anspruch 1,
wobei die erste Drehpositioniereinrichtung (24) dazu konfiguriert ist, die Verbindungsantenne (7) mit einem Koordinatensystem des Prüfobjektes (4) zu drehen.

4. Messsystem nach Anspruch 1,
wobei das Positionierungssystem (2) eine dritte Drehpositioniereinrichtung (23) umfasst, die zum Drehen des Prüfobjektes (4) um eine dritte Achse (b) konfiguriert ist.

5. Messsystem nach Anspruch 4,
wobei die dritte Drehpositioniereinrichtung (23) dazu konfiguriert ist, die Verbindungsantenne (7) nicht um die dritte Achse (b) zu drehen.

6. Messsystem nach Anspruch 4,
wobei das Positionierungssystem (2) zum Positionieren des Prüfobjektes (4) in einem Kugelkoordinatensystem konfiguriert ist.

7. Messsystem nach einem der Ansprüche 1 bis 6, mit einem reflexionsarmen Raum (5), wobei die Messantenne (6), die Verbindungsantenne (7) und das Positionierungssystem (2) in dem reflexionsarmen Raum (5) angeordnet sind.

8. Messsystem nach einem der Ansprüche 1 bis 7, mit einer mit der Messantenne (6) verbundenen Messvorrichtung (30), die dazu konfiguriert ist,
- erste Messsignale zu messen, die von dem Prüfobjekt (4) ausgesendet und von der Messantenne (6) empfangen werden, und/oder
- zweite Messsignale zu erzeugen, wobei die Messantenne (6) zum Aussenden der zweiten Messsignale in Richtung des Prüfobjektes (4) konfiguriert ist.

9. Messsystem nach einem der Ansprüche 1 bis 8, mit einer Verbindungssteuerung (32), die zur Kommunikation mit dem Prüfobjekt (4) unter Einsatz der Verbindungsantenne (7) konfiguriert ist.

10. Messsystem nach Anspruch 9,
wobei die Verbindungssteuerung (32) zum Erzeugen von Verbindungssteuersignalen und Übertragen derselben an das Prüfobjekt (4) unter Einsatz der Verbindungsantenne (7) konfiguriert ist,
wobei die Verbindungssteuersignale das Prüfobjekt (4) anweisen, mindestens einen Kommunikationsparameter einzustellen.

11. Messsystem nach Anspruch 10,
wobei der mindestens eine Kommunikationsparameter einen Strahlformungsparameter und/oder einen MIMO Parameter und/oder ein Übertragungsmuster darstellt.

12. Messsystem nach einem der Ansprüche 1 bis 11,
wobei das Positionierungssystem (2) eine vierte Drehpositioniereinrichtung aufweist, die zum Drehen der Verbindungsantenne (7) um eine vierte Achse konfiguriert ist, und/oder
wobei das Positionierungssystem (2) eine Längspositioniereinrichtung aufweist, die zum Bewegen der Verbindungsantenne (7) in Längsrichtung konfiguriert ist.

13. Messsystem nach einem der Ansprüche 1 bis 12,
wobei das Positionierungssystem (2) eine fünfte Drehpositioniereinrichtung (27) aufweist, die zum Drehen des Prüfobjektes (4) um die erste Achse (c) bezüglich der Verbindungsantenne (7) konfiguriert ist.

14. Verfahren zur Durchführung von Messungen an einem Prüfobjekt (4), mit den Schritten:
- Anweisen (100) des Prüfobjektes (4), unter Verwendung einer Verbindungsantenne (7) eine Strahlformung anzunehmen,
- Positionieren (101) des Prüfobjektes (4), um den strahlformenden Strahl unter Verwendung einer ersten Drehpositioniereinrichtung (24) in Richtung der Verbindungsantenne (7) zu lenken, und
- Durchführen (103) einer Messung unter Verwendung einer Messantenne (6),
- Drehen der Verbindungsantenne um das Prüfobjekt um eine erste Achse c unter Verwendung der ersten Drehpositioniereinrichtung,
- Drehen der Messantenne um eine zweite Achse a unter Verwendung einer zweiten Drehpositioniereinrichtung.

15. Verfahren nach Anspruch 14,
wobei das Verfahren weiterhin aufeinanderfolgend, nach dem Schritt des Durchführens einer Messung, das Positionieren (104) der Messantenne (6) in einer nächsten Messposition unter Verwendung einer zweiten Drehpositioniereinrichtung (26) sowie das Durchführen von Messungen aufweist,
bis in einer Vielzahl von gewünschten Messpositionen Messungen durchgeführt worden sind.

16. Verfahren nach Anspruch 15,
wobei das Verfahren weiterhin das Bestimmen (105) eines dreidimensionalen Strahlungsmusters aus der Vielzahl von Messungen aufweist.

17. Verfahren nach einem der Ansprüche 14 bis 16,
wobei das Verfahren weiterhin, nach dem Schritt des Positionierens (101) des Prüfobjektes (4) zum Lenken des strahlformenden Strahls in Richtung der Verbindungsantenne (7) unter Verwendung einer ersten Drehpositioniereinrichtung (24), das Positionieren (102) des Prüfobjektes (4) zum Lenken des strahlformenden Strahls in Richtung der Verbindungsantenne (7) und Verwenden einer dritten Drehpositioniereinrichtung (23) aufweist.

## Revendications

1. Système de mesure comprenant une antenne de mesure (6), une antenne de liaison (7) et un système de positionnement (2),
dans lequel l'antenne de mesure (6) est configurée pour effectuer des mesures par voie aérienne sur un dispositif à l'essai (4),
dans lequel l'antenne de liaison (7) est configurée pour effectuer une communication avec le dispositif à l'essai (4),
dans lequel le système de positionnement (2) comprend
- un premier positionneur en rotation (24), configuré pour faire tourner le dispositif à l'essai (4) autour d'au moins un premier axe (c), et
- un deuxième positionneur en rotation (26), configuré pour faire tourner l'antenne de mesure (6) autour d'au moins un deuxième axe (a),
dans lequel le premier positionneur en rotation (24) est relié à l'antenne de liaison (7) et est configuré pour faire tourner l'antenne de liaison (7) autour du dispositif à l'essai (4), autour du premier axe (c).

2. Système de mesure selon la revendication 1,
dans lequel le premier positionneur en rotation (24) est configuré pour
- faire tourner l'antenne de liaison (7) conjointement avec le dispositif à l'essai (4) autour d'une position du dispositif à l'essai (4), et
- ne pas modifier un alignement du dispositif à l'essai (4) par rapport à l'antenne de liaison (7).

3. Système de mesure selon la revendication 1,
dans lequel le premier positionneur en rotation (24) est configuré pour faire tourner l'antenne de liaison (7) avec un système de coordonnées du dispositif à l'essai (4).

4. Système de mesure selon la revendication 1,
dans lequel le système de positionnement (2) comprend un troisième positionneur en rotation (23), configuré pour faire tourner le dispositif à l'essai (4) autour d'un troisième axe (b).

5. Système de mesure selon la revendication 4,
dans lequel le troisième positionneur en rotation (23) est configuré pour ne pas faire tourner l'antenne de liaison (7) autour du troisième axe (b).

6. Système de mesure selon la revendication 4,
dans lequel le système de positionnement (2) est configuré pour positionner le dispositif à l'essai (4) dans un système de coordonnées sphériques.

7. Système de mesure selon l'une quelconque des revendications 1 à 6, comprenant une chambre anéchoïque (5),
dans lequel l'antenne de mesure (6), l'antenne de liaison (7) et le système de positionnement (2) sont agencés dans la chambre anéchoïque (5).

8. Système de mesure selon l'une quelconque des revendications 1 à 7, comprenant un dispositif de mesure (30) relié à l'antenne de mesure (6), configuré pour
- mesurer des premiers signaux de mesure émis par le dispositif à l'essai (4) et reçus par l'antenne de mesure (6), et/ou
- générer des seconds signaux de mesure, dans lequel l'antenne de mesure (6) est configurée pour émettre les seconds signaux de mesure en direction du dispositif à l'essai (4).

9. Système de mesure selon l'une quelconque des revendications 1 à 8,
comprenant un contrôleur de liaison (32), configuré pour communiquer avec le dispositif à l'essai (4), à l'aide de l'antenne de liaison (7).

10. Système de mesure selon la revendication 9,
dans lequel le contrôleur de liaison (32) est configuré pour générer des signaux de commande de liaison et les transmettre au dispositif à l'essai (4), à l'aide de l'antenne de liaison (7), dans lequel les signaux de commande de liaison ordonnent au dispositif à l'essai (4) de régler au moins un paramètre de communication.

11. Système de mesure selon la revendication 10,
dans lequel le au moins un paramètre de communication est un paramètre de formation de faisceau et/ou un paramètre d'entrées multiples et sorties multiples MIMO et/ou un diagramme d'émission.

12. Système de mesure selon l'une quelconque des revendications 1 à 11,
dans lequel le système de positionnement (2) comprend un quatrième positionneur en rotation, configuré pour faire tourner l'antenne de liaison (7) autour d'un quatrième axe, et/ou
dans lequel le système de positionnement (2) comprend un positionneur longitudinal, configuré pour déplacer l'antenne de liaison (7) de manière longitudinale.

13. Système de mesure selon l'une quelconque des revendications 1 à 12, dans lequel le système de positionnement (2) comprend un cinquième positionneur en rotation (27), configuré pour faire tourner le dispositif à l'essai (4) autour du premier axe (c) par rapport à l'antenne de liaison (7).

14. Procédé pour effectuer des mesures sur un dispositif à l'essai (4), consistant à :
- ordonner (100) au dispositif à l'essai (4) d'adopter une formation de faisceau, à l'aide d'une antenne de liaison (7),
- positionner (101) le dispositif à l'essai (4) pour diriger le faisceau de formation de faisceau en direction de l'antenne de liaison (7), à l'aide d'un premier positionneur en rotation (24), et
- effectuer (103) une mesure, à l'aide d'une antenne de mesure (6),
- faire tourner l'antenne de liaison autour du dispositif à l'essai autour d'un premier axe c à l'aide du premier positionneur en rotation,
- faire tourner l'antenne de mesure autour d'un deuxième axe a à l'aide d'un deuxième positionneur en rotation.

15. Procédé selon la revendication 14,
dans lequel le procédé consiste en outre, successivement, après l'étape consistant à effectuer une mesure, à positionner (104) l'antenne de mesure (6) à une position de mesure suivante, à l'aide d'un second positionneur en rotation (26), et à effectuer des mesures,
jusqu'à ce que des mesures à une pluralité de positions de mesure souhaitées aient été effectuées.

16. Procédé selon la revendication 15,
dans lequel le procédé consiste en outre à déterminer (105) d'un diagramme de rayonnement tridimensionnel à partir de la pluralité de mesures.

17. Procédé selon l'une quelconque des revendications 14 à 16,
dans lequel le procédé consiste en outre, après l'étape de positionnement (101) du dispositif à l'essai (4) pour diriger le faisceau de formation de faisceau en direction de l'antenne de liaison (7), à l'aide d'un premier positionneur en rotation (24), à positionner (102) le dispositif à l'essai (4) pour diriger le faisceau de formation de faisceau en direction de l'antenne de liaison (7) et à l'aide d'un troisième positionneur en rotation (23).
